# EUROPÄISCHE PATENTSCHRIFT

(11) **EP 2 942 851 B1**
(45) Veröffentlichungstag und Bekanntmachung des Hinweises auf die Patenterteilung: **13.07.2016**
(21) Anmeldenummer: 14167629.6
(22) Anmeldetag: 09.05.2014
(51) Int. Cl.: H02H 9/02

(54) **Verfahren zur Überwachung der Leistungsaufnahme eines elektrischen Verbrauchers**
Method for monitoring the power consumption of an electrical consumer
Procédé de surveillance de la puissance d'un consommateur électrique

(43) Veröffentlichungstag der Anmeldung: 11.11.2015
(73) Patentinhaber: dSPACE digital signal processing and control engineering GmbH, 33102 Paderborn (DE)
(72) Erfinder: Völzke, Florian, 33102 Paderborn (DE)

(56) Entgegenhaltungen:
- EP-A2- 2 562 896
- US-A1- 2012 087 053
- US-A1- 2013 021 702

## Beschreibung

Die Erfindung betrifft ein Verfahren zur Überwachung der Leistungsaufnahme eines elektrischen Verbrauchers gemäß dem Oberbegriff des Patentanspruchs 1. Die Erfindung betrifft zudem eine elektronische Sicherung in Form einer Vorrichtung gemäß dem Oberbegriff des Patentanspruchs 10.

Steuerbare elektronische Sicherungen zur Überwachung einer Leistungsaufnahme sind aus dem Stand der Technik bekannt. Die Druckschrift WO 2000/13279 beschreibt eine Schaltungsanordnung für eine elektronische Sicherung, deren Stromfluss durch ein Stellglied abhängig von einer anliegenden Spannung geregelt ist. Die Druckschrift US 8 299 767 B2 beschreibt eine Ansteuerung eines Transistors anhand einer Überwachung der Leistungsaufnahme des Transistors. Ein Schaltkreis zur Begrenzung von Einschaltströmen unter Anwendung eines Modellkondensators ist aus der Druckschrift US 2013/0021 702 A1 bekannt. Diese Druckschrift formt den Oberbegriff der unabhängigen Ansprüche 1 und 10. Die Druckschrift US 2012/0087 053 A1 beschreibt ein Netzteil mit einer Schaltung zum Schutz vor Überströmen.

Vor diesem Hintergrund besteht die Aufgabe der Erfindung darin, eine Vorrichtung anzugeben, die den Stand der Technik weiterbildet.

Die Aufgabe wird durch ein Verfahren zur Überwachung der Leistungsaufnahme eines elektrischen Verbrauchers mit den Merkmalen des Patentanspruchs 1 und durch eine Vorrichtung mit den Merkmalen des Patentanspruchs 10 gelöst. Vorteilhafte Ausgestaltungen der Erfindung sind Gegenstand von Unteransprüchen.

Gemäß dem Gegenstand der Erfindung wird ein Verfahren zur Überwachung der Leistungsaufnahme eines elektrischen Verbrauchers ausgebildet, wobei der Verbraucher eine kapazitive Last aufweist, wobei das steuerbare Schaltelement und der elektrische Verbraucher in Serie geschaltet werden, die Stromstärke des durch den Verbraucher fließenden Stroms erfasst wird, die über den Verbraucher abfallende Spannung erfasst wird, die zeitliche Änderung der über den Verbraucher abfallenden Spannung erfasst wird, aus der über den Verbraucher abfallenden Spannung und aus einem vorgegebenen Maximalwert für die Leistungsaufnahme des elektrischen Verbrauchers eine erlaubte Betriebsstromstärke errechnet wird, aus der zeitlichen Änderung der über den Verbraucher abfallenden Spannung eine Ladestromstärke der kapazitiven Last errechnet wird, unter Berücksichtigung der erlaubten Betriebsstromstärke und der Ladestromstärke eine erlaubte momentane Stromstärke errechnet wird, die erlaubte momentane Stromstärke mit der Stromstärke des durch den Verbraucher fließenden Stroms verglichen wird und der elektrische Widerstand des Schaltelements erhöht wird, wenn die Stromstärke des durch den Verbraucher fließenden Stroms größer ist als die erlaubte momentane Stromstärke.

Es sei angemerkt, dass mit der kapazitiven Last des Verbrauchers eine Nettokapazität des Verbrauchers gemeint ist, die sich als Summe der Kapazitäten mehrerer im Verbraucher verbauter elektrischer Komponenten darstellen kann. Unter der erlaubten momentanen Stromstärke wird erfindungsgemäß ein erlaubter Maximalwert der zu einem gegebenen Zeitpunkt physisch messbaren, instantanen Stromstärke des Eingangsstroms in den Verbraucher verstanden. Unter der Ladestromstärke wird erfindungsgemäß die Stromstärke des Anteils des Eingangsstroms in den Verbraucher verstanden, der zu einem gegebenen Zeitpunkt zur Ladung oder Entladung der kapazitiven Last des Verbrauchers aufgewandt wird. Unter der Betriebsstromstärke wird die Stromstärke verstanden, die sich aus der Stromstärke des durch den Verbraucher fließenden Stroms abzüglich der Ladestromstärke ergibt.

Ein Vorteil der Erfindung ist es, dass sie den sicheren Betrieb eines elektrischen Verbrauchers in unterschiedlichen Stromnetzen mit unterschiedlichen Betriebsspannungen erlaubt. Insbesondere in der Automobiltechnik sind unterschiedliche Standards von Bordstromnetzen verbreitet, die im Normalbetrieb unterschiedliche Betriebsspannungen vorsehen, beispielsweise 12V, 24V, 42V oder 48V. Im Zusammenhang der Entwicklung und des Tests von Software für Kraftfahrzeugsteuergeräte ist es aus dem Stand der Technik bekannt, tragbare programmierbare Steuereinheiten mit dem Bordstromnetz zu verbinden und vorübergehend die Funktion eines Kraftfahrzeugsteuergeräts übernehmen zu lassen. Durch die dynamische Anpassung der erlaubten momentanen Stromstärke an die aktuell anliegende Eingangsspannung ermöglicht die Erfindung den Bau einer elektronischen Sicherung, die die tragbare programmierbare Steuereinheit bei unterschiedlichen Eingangsspannungen gegen Überlastung schützt, ohne den Betrieb der tragbaren programmierbaren Steuereinheit durch Fehlauslösungen zu beinträchtigen. Ein und dieselbe tragbare programmierbare Steuereinheit ist in unterschiedlichen Bordnetzen ohne Austausch des Netzteils verwendbar.

Ein weiterer Vorteil der Erfindung ist, dass zusätzlich zu unterschiedlichen Betriebsspannungen auch kurzzeitige Spannungsschwankungen erkannt und berücksichtigt werden. Schwankungen der Ausgangsspannung können insbesondere auch im Bordstromnetz durch das Zu- und Abschalten von Verbrauchern auftreten, vor allem dann, wenn das Fahrzeug bei abgeklemmter Batterie betrieben wird oder wenn die Batterie bei laufendem Motor abgeklemmt wird. Um in einer derartigen Umgebung zuverlässig zu funktionieren, muss eine elektronische Sicherung während eines Überspannungspulses einen entsprechend niedrigeren Wert für die erlaubte Betriebsstromstärke aufweisen, um eine zu hohe Leistungsaufnahme durch den Verbraucher zu verhindern.

Wiederum ein weiterer Vorteil der Erfindung ist, dass die durch die genannten Schwankungen der Ausgangsspannung hervorgerufenen Ladeströme kapazitiver Lasten des Verbrauchers erkannt werden. Der Ladestrom einer kapazitiven Last, beispielsweise eines Kondensators, ergibt sich gemäß der Formel I = C*dU/dT aus dem Produkt der Kapazität der kapazitiven Last und der zeitlichen Änderung der Eingangsspannung. Kurzzeitige Spannungsschwankungen können dementsprechend zu kurzzeitigen, unter Umständen sehr starken Ladeströmen kapazitiver Lasten führen, und es ist im Allgemeinen nicht erwünscht, dass diese Ladeströme unmittelbar zu einer Auslösung der elektronischen Sicherung führen. Durch die separate Erfassung der Ladestromstärke kapazitiver Lasten des Verbrauchers werden diese Ladeströme als solche erkannt und bei der Festlegung der erlaubten momentanen Stromstärke berücksichtigt.

In einer bevorzugten Weiterbildung der Erfindung enthält die Berechnung der erlaubten momentanen Stromstärke zusätzlich einen vorgegebenen Gleichanteil, um Fehlauslösungen der elektronischen Sicherung infolge von Ungenauigkeiten bei der Berechnung der erlaubten Betriebsstromstärke oder Ladestromstärke entgegenzuwirken.

In einer vorteilhaften Ausgestaltung der Erfindung wird die Ladestromstärke mittels einer analogen Schaltung ermittelt. Eine digitale Schaltung, bei der die analoge Ladestromstärke erst mittels eines Analog-Digital-Wandlers in einen digitalen Wert umgewandelt werden müsste, wäre angesichts der Zeit, die für die Wandlung der analogen Stromstärke in einen digitalen Wert und dessen anschließender digitaler Auswertung aufgebracht werden müsste, zu träge, um einen Ladestrom rechtzeitig zu erkennen und eine Fehlauslösung der elektronischen Sicherung zu vermeiden. In einer besonders vorteilhaften Ausgestaltung wird die Ladestromstärke mittels eines Modellkondensators ermittelt. Unter einem Modellkondensator wird erfindungsgemäß ein Kondensator verstanden, der zu dem Verbraucher parallel geschaltet ist und dessen Kapazität wesentlich kleiner als die Kapazität der kapazitiven Last des Verbrauchers ist, sodass die Messung der Ladestromstärke mittels des Modellkondensators nicht das Ergebnis verfälscht. Mittels eines Messwiderstands wird der durch den Modellkondensator fließende Strom gemessen und aus diesem auf den Ladestrom der kapazitiven Last des Verbrauchers geschlossen. In einer weiterhin besonders vorteilhaften Ausgestaltung wird der durch den Kondensator fließende Strom mittels eines Spitzenwertdetektors gemessen, um Unterschätzungen der Ladestromstärke aufgrund von Induktivitäten und/oder kapazitiven Lasten und/oder ohmschen Lasten im Verbraucher zu verhindern.

In einer weiterhin vorteilhaften Ausgestaltung wird die erlaubte Betriebsstromstärke mittels einer digitalen Schaltung ermittelt. Anders als bei der Ladestromstärke bestehen hier keine besonderen Anforderungen an die Schnelligkeit der Ermittlung, und da die erlaubte Betriebsstromstärke sich aus einer Division der erlaubten Leistungsaufnahme durch die aktuelle Betriebsspannung ergibt und eine Division mit einer analogen Schaltung schwer umsetzbar ist, ist eine digitale Schaltung an dieser Stelle vorteilhaft.

In einer Ausgestaltung der Erfindung wird das Schaltelement in einen nichtleitenden Zustand versetzt, sobald die Stromstärke des durch den Verbraucher fließenden Stroms größer ist als die erlaubte momentane Stromstärke.

In einer bevorzugten Ausführung ist das Schaltelement ein Transistor, insbesondere ein MOSFET, dessen elektrischer Widerstand durch eine Ansteuerung der Gatespannung geregelt wird. In einer Ausgestaltung wird die Gatespannung auf null gesetzt, sobald die Stromstärke des durch den Verbraucher fließenden Stroms größer ist als die erlaubte momentane Stromstärke, sodass der Transistor in einen nichtleitenden Zustand versetzt wird. In einer anderen Ausgestaltung wird die Gatespannung in diesem Fall zumindest vorübergehend reduziert, aber nicht auf null gesetzt, sodass der Transistor in einen Zustand des erhöhten elektrischen Widerstands versetzt wird und ein Teil der anliegenden Spannung über den Transistor abfällt.

In einer weiterhin bevorzugten Ausführung sind der elektrische Verbraucher und das Schaltelement vorgesehen und ausgestaltet, um an ein Bordstromnetz mit einer Betriebsspannung im Bereich von 12V bis 48V angeschlossen zu werden.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: ein Prinzipschaltbild der erfindungsgemäßen Vorrichtung in einer bevorzugte Ausführung und eines elektrischen Verbrauchers,
- Figur 2: ein detailliertes Schaltbild der erfindungsgemäßen Vorrichtung in einer bevorzugten Ausführung,
- Figur 3: in einer qualitativen Darstellung die Verfälschung eines idealen Ladevorgangs einer kapazitiven Last durch einen der kapazitiven Last vorgeschalteten ohmschen Widerstand und
- Figur 4: in einer weiteren qualitativen Darstellung die Berücksichtigung dieser Verfälschung durch einen Spitzenwertdetektor.

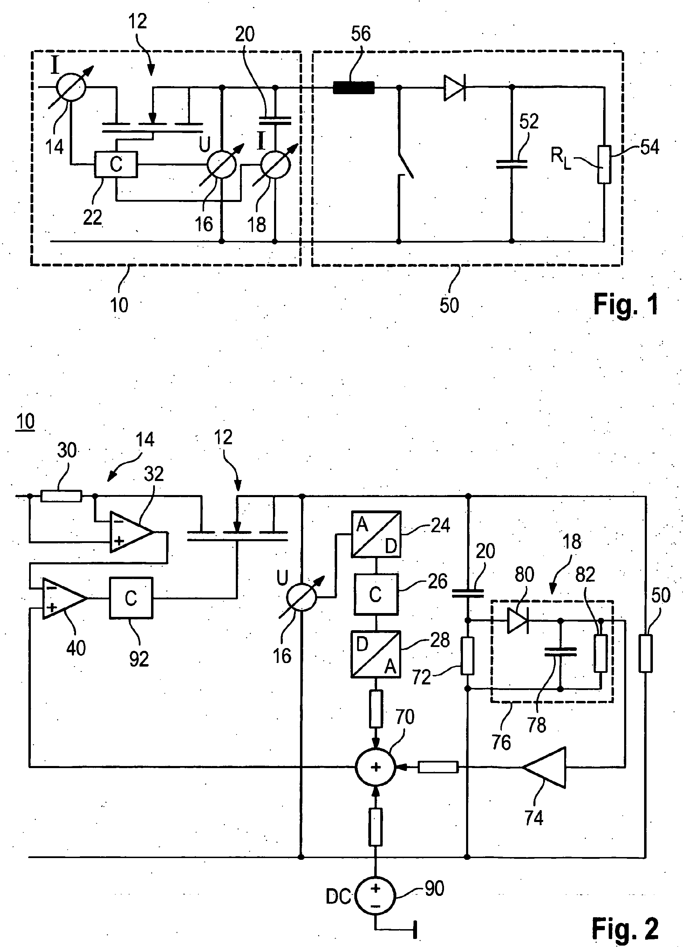

Die Abbildung der Figur 1 zeigt eine elektronische Sicherung in Form einer erfindungsgemäßen Vorrichtung 10 in einer bevorzugten Ausführung sowie einen elektrischen Verbraucher 50. Die Vorrichtung 10 weist ein Schaltelement 12 in Form eines Transistors auf, der mit dem elektrischen Verbraucher 50 in Serie geschaltet ist. Die Vorrichtung 10 beinhaltet weiterhin eine Steuervorrichtung zur Regelung der Gatespannung des Schaltelements 12. Die Steuervorrichtung weist erfindungsgemäß eine erste Messvorrichtung 14 zur Messung der Stromstärke des durch den Verbraucher 50 fließenden Stroms auf. Die Steuervorrichtung weist erfindungsgemäß weiterhin eine zweite Messvorrichtung 16 zur Messung der über den Verbraucher 50 abfallenden Spannung auf. Die Steuervorrichtung weist erfindungsgemäß weiterhin eine dritte Messvorrichtung 18 zur Messung der Stromstärke des Ladestroms einer kapazitiven Last des Verbrauchers 50 auf, wobei die dritte Messvorrichtung 18 bevorzugt ausgestaltet ist, um die Stromstärke des durch einen zu dem Schaltelement 12 und dem Verbraucher 50 parallel geschalteten Modellkondensator 20 fließenden Stroms zu messen. Die Steuervorrichtung weist erfindungsgemäß weiterhin eine Auswerteeinheit 22 auf, die die von der ersten Messvorrichtung 14, der zweiten Messvorrichtung 16 und der dritten Messvorrichtung 18 erzeugten Messgrößen ausliest und die Gatespannung des Schaltelements 12 als eine Funktion dieser drei Messgrößen regelt. In einer Ausgestaltung der Erfindung umfasst die Auswerteeinheit 22 zumindest einen Komparator und einen Mikrocontroller.

Der elektrische Verbraucher 50 umfasst bevorzugt ein Schaltnetzteil in Form eines Gleichstromwandlers, insbesondere eines Hochsetzstellers, und eine elektrische Last 54, beispielsweise eine dSPACE AutoBox. Das Schaltnetzteil und die elektronische Sicherung 10 sind bevorzugt vorgesehen und ausgestaltet, um an ein Gleichstromnetz, insbesondere ein Bordstromnetz, mit einer typischen Betriebsspannung im Bereich von 12V bis 48V angeschlossen zu werden. Der Gleichstromwandler umfasst mindestens einen Kondensator 52. Zusammen mit weiteren Kondensatoren oder anderen kapazitiven Komponenten im Schaltnetzteil und der Last 54 bildet er die kapazitive Last des Verbrauchers 50. Der Gleichstromwandler umfasst weiterhin mindestens eine Induktivität 56, die den Ladevorgang der kapazitiven Last beeinflusst. Es sei angemerkt, dass der Hochsetzsteller in einer idealisierten und dadurch stark vereinfachten Form dargestellt ist.

Die Abbildung der Figur 2 zeigt eine detaillierte Schaltskizze der erfindungsgemäßen Vorrichtung 10 in einer besonders bevorzugten Ausführung. Die erste Messvorrichtung 14 ist ausgestaltet in Form eines Messwiderstands 30. Ein Differenzverstärker 32 misst den Spannungsabfall über den Messwiderstand 30, multipliziert diesen mit dem Kehrwert des elektrischen Widerstands des Messwiderstands 30 und leitet das Ergebnis in Form eines analogen Signals an einen Komparator 40 weiter.

Die zweite Messvorrichtung 16 zur Messung der über den Verbraucher 50 abfallenden Spannung ist in Form eines Spannungsmessers ausgestaltet, der den gemessenen Wert in Form eines analogen Signals an einen Analog-Digital-Wandler 24 weiterleitet. Ein Mikrocontroller 26 errechnet aus dem digitalen Wert einen Wert für die erlaubte Betriebsstromstärke, indem er einen vorgegebenen Maximalwert für die Leistungsaufnahme des Verbrauchers 50 durch die von der zweiten Messvorrichtung 16 gemessene Spannung teilt. Den errechneten Wert für die erlaubte Betriebsstromstärke leitet er an einen Digital-Analog-Wandler 28 weiter, der ihn wiederum in Form eines analogen Signals an eine Additionseinheit 70 weiterleitet. Der Analog-Digital-Wandler 24, der Mikrocontroller 26, der Digital-Analog-Wandler 28 und die Additionseinheit 70 sind als Komponenten der Auswerteeinheit 22 zu verstehen.

Die dritte Messvorrichtung 18 zur Messung der Stromstärke des Ladestroms einer kapazitiven Last des Verbrauchers 50 ist in Form eines Modellkondensators 20 und einer Schaltung zur Überwachung des Ladestroms des Modellkondensators 20 ausgebildet. Der Modellkondensator 20 ist zu dem Verbraucher 50 parallel geschaltet. Die Messung der Stromstärke des durch den Modellkondensator 20 fließenden Stroms geschieht durch einen Messwiderstand 72. Ein Verstärker 74 misst zu diesem Zweck die über den Messwiderstand 72 abfallende Spannung, multipliziert diese mit einem Faktor C2/(C1*R), wobei C1 die Kapazität des Modellkondensators 20, C2 die Kapazität der kapazitiven Last des Verbrauchers 50 und R der elektrische Widerstand des Messwiderstands 72 ist, und leitet das Ergebnis in Form eines analogen Signals an die Additionseinheit 70 weiter.

In einer besonders bevorzugten Ausgestaltung misst der Verstärker 74 die über den Messwiderstand 72 abfallende Spannung mittels eines Spitzenwertdetektors 76. Dieser wird gebildet durch einen zum Messwiderstand 72 parallel geschalteten Kondensator 78, eine Diode 80 und einen Widerstand 82. Dabei sind die Komponenten des Spitzenwertdetektors 76 derart angeordnet, dass der Kondensator 78 zunächst auf eine Spannung aufgeladen wird, die der über den Messwiderstand 72 abfallenden Spannung entspricht, und sich dann über den Widerstand 82 langsam entlädt. Der Verstärker misst in dieser bevorzugten Ausgestaltung die Spannung des Kondensators 78 des Spitzenwertdetektors 76.

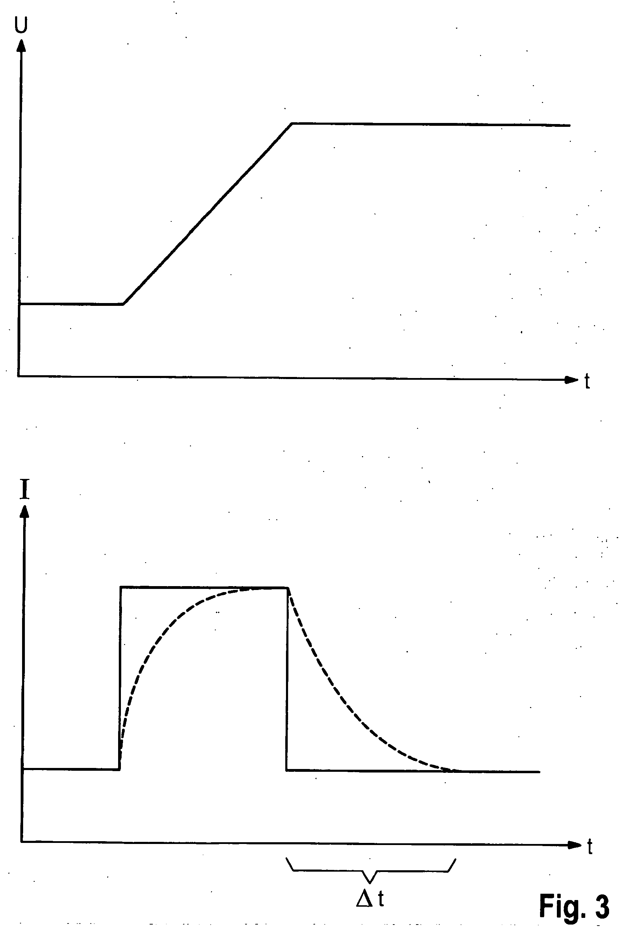

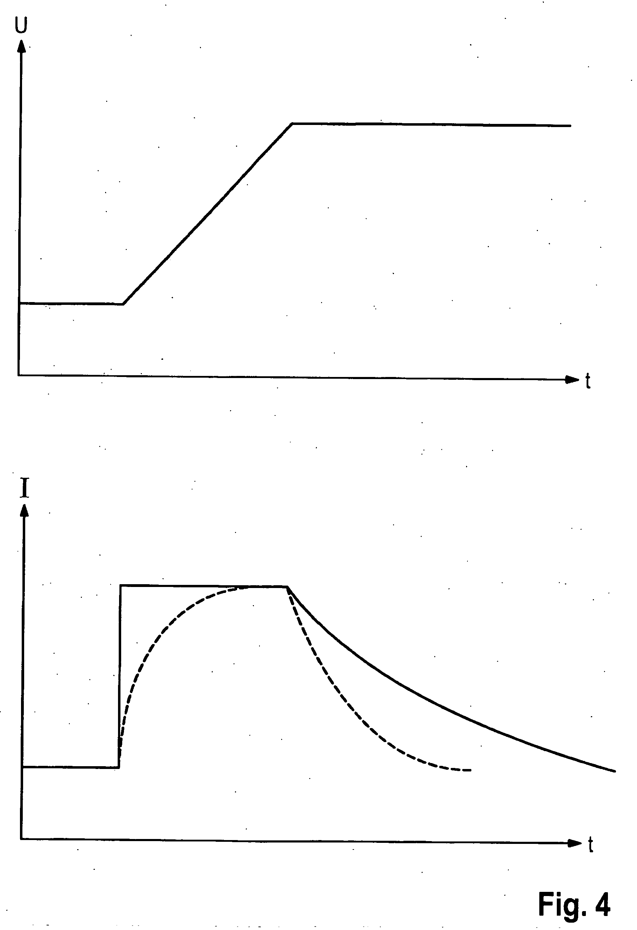

Die Verwendung eines Spitzenwertdetektors in der eben beschriebenen Weise verhindert eine Unterschätzung der Ladestromstärke der kapazitiven Last des Verbrauchers 50 für den Fall, dass der Stromverlauf durch einen zusätzlichen induktiven Anteil und/oder einen Serienwiderstand beeinflusst wird. Das Prinzip erläutern die Figuren 3 und 4.
Figur 3 zeigt in der oberen Auftragung eine angenommene Schwankung der Betriebsspannung in Form eines linearen Spannungsanstiegs. Die untere Auftragung zeigt mit der durchgezogenen Kurve den daraus resultierenden Ladestrom des Modellkondensators 20. Dieser ist der Spannungsversorgung des Stromnetzes unmittelbar ausgeliefert und verhält sich deshalb annähernd wie ein idealer Kondensator. Die gestrichelte Kurve zeigt einen beispielhaften Ladestrom der kapazitiven Last des Verbrauchers 50 für den Fall eines der kapazitiven Last vorgeschalteten ohmschen Widerstands. Diese ist dem Einfluss einer Vielzahl von Widerständen ausgesetzt, die die Ladung der kapazitiven Last des Verbrauchers 50 verzögern. Wie aus den Kurven ersichtlich ist, führt dies innerhalb eines Zeitintervalls Δt zu einer Unterschätzung des Ladestroms. Diese Unterschätzung wiederum kann eine Fehlauslösung der elektronischen Sicherung bewirken.

Figur 4 zeigt in der oberen Auftragung dieselbe angenommene Spannungsschwankung wie in Figur 3. Die untere Auftragung zeigt mit der durchgezogenen Kurve den am Modellkondensator 20 gemessenen Ladestrom unter Verwendung eines Spitzenwertdetektors. Wie aus der Auftragung ersichtlich ist, kommt es nun zu jedem Zeitpunkt zu einer Überschätzung des Ladestroms der kapazitiven Last des Verbrauchers 50. Fehlauslösungen der elektronischen Sicherung aufgrund von Unterschätzungen des Ladestroms werden auf diese Weise verhindert. Durch geschickte Auswahl des Kondensators 78 und des Widerstands 82 des Spitzenwertdetektors ist der Spitzenwertdetektor so konstruierbar, dass er sich nur wenig langsamer als die kapazitive Last des Verbrauchers 50 entlädt, sodass die Überschätzung des Ladestroms gering ausfällt.

Die in Figur 2 gezeigte Ausführung der erfindungsgemäßen Vorrichtung 10 weist zusätzlich einen konstanten Signalgenerator 90 auf, der ein konstantes analoges Signal an die Additionseinheit 70 leitet. Auf diese Weise prägt er den durch die zweite Messvorrichtung 16 und die dritte Messvorrichtung 18 erzeugten Signalen einen Gleichanteil auf und wirkt dadurch Fehlauslösungen der elektronischen Sicherung als Folge von Messfehlern entgegen.

Die Additionseinheit 70 errechnet durch Addition der drei ihr zugeführten analogen Signale die erlaubte momentane Stromstärke und leitet deren Wert in Form eines analogen Signals an den Komparator 40 weiter, der sie mit der Stromstärke des durch den Verbraucher 50 fließenden Stroms vergleicht. Der Komparator 40 leitet das Ergebnis des Vergleichs in Form eines binären Signals an einen Mikroprozessor 92 weiter. Der Mikroprozessor 92 regelt die Gatespannung des Schaltelements und erhöht dessen elektrischen Widerstand wenn die Stromstärke des durch den Verbraucher 50 fließenden Stroms größer ist als die erlaubte momentane Stromstärke. Weil die durch die dritte Messeinheit 18 erfassten Ladeströme der kapazitiven Last des Verbrauchers 50 immer auf die erlaubte momentane Stromstärke aufaddiert werden, führen sie niemals zu einer Auslösung der Sicherung.

Es versteht sich, dass die in Figur 2 gezeigte Ausführungsform beispielhaft ist und für den Fachmann offensichtliche Variationen möglich sind, die unter den Oberbegriff des Anspruchs 1 oder des Anspruchs 10 fallen. Insbesondere ist die Ausgestaltung der Signalauswertung und der Ansteuerung des Schaltelements 12 durch die Auswerteeinheit 22 auch anders ausgestaltbar, beispielsweise derart, dass auch Ladeströme der kapazitiven Last des Verbrauchers unter Umständen zu einem Auslösen der elektronischen Sicherung, d.h. zu einer Erhöhung des elektrischen Widerstands des Schaltelements 12 führen können.

## Patentansprüche

1. Verfahren zur Überwachung der Leistungsaufnahme eines elektrischen Verbrauchers (50) mittels eines steuerbaren Schaltelements (12), wobei der elektrische Verbraucher (50) eine kapazitive Last aufweist,
das steuerbare Schaltelement (12) und der elektrische Verbraucher (50) in Serie geschaltet werden;
die Stromstärke des durch den elektrischen Verbraucher (50) fließenden Stroms erfasst wird;
die über den elektrischen Verbraucher (50) abfallende Spannung erfasst wird;
und die zeitliche Änderung der über den elektrischen Verbraucher (50) abfallenden Spannung erfasst wird;
**dadurch gekennzeichnet, dass** aus der über den elektrischen Verbraucher (50) abfallenden Spannung und aus einem vorgegebenen Maximalwert für die Leistungsaufnahme des elektrischen Verbrauchers (50) eine erlaubte Betriebsstromstärke errechnet wird;
aus der zeitlichen Änderung der über den elektrischen Verbraucher (50) abfallenden Spannung eine Ladestromstärke der kapazitiven Last errechnet wird;
unter Berücksichtigung der erlaubten Betriebsstromstärke und der Ladestromstärke eine erlaubte momentane Stromstärke errechnet wird;
die erlaubte momentane Stromstärke mit der Stromstärke des durch den Verbraucher fließenden Stroms verglichen wird und
der elektrische Widerstand des Schaltelements (12) erhöht wird, wenn die Stromstärke des durch den elektrischen Verbraucher (50) fließenden Stroms größer ist als die erlaubte momentane Stromstärke.

2. Verfahren nach Anspruch 1, wobei die erlaubte momentane Stromstärke aus der erlaubten Betriebsstromstärke, der Ladestromstärke und einem vorgegebenen Gleichanteil errechnet wird.

3. Verfahren nach Anspruch 1 oder 2, wobei die erlaubte Betriebsstromstärke mittels einer digitalen Schaltung (26) errechnet wird.

4. Verfahren nach Anspruch 1 oder 2, wobei die zeitliche Änderung der über den Verbraucher abfallenden Spannung mittels einer analogen Schaltung erfasst wird.

5. Verfahren nach Anspruch 4, wobei ein Modellkondensator (20) zu dem elektrischen Verbraucher (50) parallel geschaltet wird, der Ladestrom des Modellkondensators (20) erfasst wird und aus dem Ladestrom des Modellkondensators (20) die zeitliche Änderung der über den Verbraucher (50) abfallenden Spannung errechnet wird.

6. Verfahren nach Anspruch 5, wobei ein Messwiderstand (72) mit dem Modellkondensator (20) in Serie geschaltet wird und ein Spitzenwertdetektor (76) zu dem Messwiderstand parallel geschaltet wird, wobei die Spannung des Spitzenwertdetektors (76) ermittelt wird und aus der Spannung des Spitzenwertdetektors (76) der Ladestrom des Modellkondensators (20) errechnet wird.

7. Verfahren nach einem der vorhergehenden Ansprüche, wobei das Schaltelement (12) in einen nichtleitenden Zustand versetzt wird, wenn die Stromstärke des durch den Verbraucher (50) fließenden Stroms größer ist als die erlaubte momentane Stromstärke.

8. Verfahren nach einem der vorhergehenden Ansprüche, wobei das Schaltelement (12) ein Transistor ist und durch eine Ansteuerung der Gatespannung oder der Basisspannung des Transistors der elektrische Widerstand des Transistors geregelt wird.

9. Verfahren nach einem der vorhergehenden Ansprüche, wobei der elektrische Verbraucher (50) und das Schaltelement (12) an ein Bordnetz mit einer Betriebsspannung im Bereich von 12V bis 48V angeschlossen werden.

10. Vorrichtung (10) zur Überwachung der Leistungsaufnahme eines elektrischen Verbrauchers (50), wobei der Verbraucher eine kapazitive Last aufweist, wobei die Vorrichtung (10) ein steuerbares Schaltelement (12) und eine Steuervorrichtung (22) für das steuerbare Schaltelement (12) aufweist, wobei die Vorrichtung (10) und der elektrische Verbraucher (50) derart elektrisch verbunden sind, dass das Schaltelement (12) und der elektrische Verbraucher (50) in Serie geschaltet sind, wobei die Steuervorrichtung (22) ausgestaltet ist, die Stromstärke des durch den Verbraucher fließenden Stroms, die über den Verbraucher abfallende Spannung und mittels einer analogen Schaltung durch Erfassung des Ladestroms eines Modellkondensators (20) die zeitliche Änderung der über den elektrischen Verbraucher (50) abfallenden Spannung zu erfassen, **dadurch gekennzeichnet, dass** die Steuervorrichtung weiterhin ausgestaltet ist, aus der über den elektrischen Verbraucher (50) abfallenden Spannung und einem vorgegebenen Maximalwert für die Leistungsaufnahme des elektrischen Verbrauchers (50) mittels einer digitalen Rechenoperation eine erlaubte Betriebsstromstärke zu errechnen, aus der zeitlichen Änderung der über den elektrischen Verbraucher (50) abfallenden Spannung eine Ladestromstärke der kapazitiven Last zu errechnen, aus der erlaubten Betriebsstromstärke und der Ladestromstärke eine erlaubte momentane Stromstärke zu errechnen, die erlaubte momentane Stromstärke mit der Stromstärke des durch den elektrischen Verbraucher (50) fließenden Stroms mittels eines Komparators (40) zu vergleichen und den elektrischen Widerstand des Schaltelements (12) zu erhöhen, wenn die Stromstärke des durch den elektrischen Verbraucher (50) fließenden Stroms größer ist als die erlaubte momentane Stromstärke.

11. Vorrichtung (10) nach Anspruch 10, wobei die Vorrichtung (10) als Komponente eines Netzteils ausgebildet ist und das Netzteil als Gleichstromwandler, insbesondere als Hochsetzsteller ausgebildet ist.

12. Vorrichtung (10) nach Anspruch 11, wobei das Netzteil ausgestaltet und vorgesehen ist, einen elektrischen Verbraucher (54) an ein Bordnetz mit einer Betriebsspannung von im Bereich von 12V bis 48V anzuschließen.

## Claims

1. A method for monitoring the power consumption of an electrical consumer (50) by means of a controllable switching element (12), the electrical consumer (50) comprising a capacitive load,
the controllable switching element (12) and the electrical consumer (50) being connected in series,
the current flowing through the electrical consumer (50) being measured,
the voltage drop across the electrical consumer (50) being measured,
and the change over time of the voltage drop across the electrical consumer (50) being measured,
**characterized in that**, a permissible operating current level is calculated from the voltage drop across the electrical consumer (50) and from a prescribed maximum value for the power consumption of the electrical consumer (50);
a charging current level of the capacitive load is calculated from the change over time of the voltage drop across the electrical consumer (50);
a permissible instantaneous current level is calculated using the permissible operating current level and the charging current level;
the permissible instantaneous current level is compared with the level of the current flowing through the consumer and the electrical resistance of the switching element (12) is increased if the level of the current flowing through the electrical consumer (50) is greater than the permissible instantaneous current level.

2. The method according to claim 1, **characterized in that** the permissible instantaneous current level is calculated from the permissible operating current level, the charging current level, and a prescribed constant component.

3. The method according to claim 1 or 2, **characterized in that** the permissible operating current level is calculated by means of a digital circuit (26).

4. The method according to claim 1 or 2, **characterized in that** the change over time of the voltage drop across the consumer is detected by means of an analog circuit.

5. The method according to claim 4, **characterized in that** a model capacitor (20) is connected in parallel with the consumer (5), the charging current of the model capacitor (20) is measured, and the change over time of the voltage drop across the consumer (50) is calculated from the charging current of the model capacitor (20).

6. The method according to claim 5, **characterized in that** a measuring resistor (72) is connected in series with the model capacitor (20) and a peak detector (76) is connected in parallel with the measuring resistor, **characterized in that** the voltage of the peak detector (76) is determined and the charging current of the model capacitor (20) is calculated from the voltage of the peak detector (76).

7. The method according to any one of the preceding claims, **characterized in that** the switching element (12) is placed in a non-conducting state if the level of the current flowing through the consumer (50) is greater than the permissible instantaneous current level.

8. The method according to any one of the preceding claims, **characterized in that** the switching element (12) is a transistor and the electrical resistance of the transistor is regulated by actuating the gate voltage or the base voltage of the transistor.

9. The method according to any one of the preceding claims, **characterized in that** the electrical consumer (50) and the switching element (12) are connected to a vehicle electrical system having an operating voltage in the range of 12V to 48V.

10. A device (10) for monitoring the power consumption of an electrical consumer (50), the consumer comprising a capacitive load, the device (10) comprising a controllable switching element (12) and a control device (22) for the controllable switching element (12), the device (10) and the electrical consumer (50) being electrically connected such that the switching element (12) and the electrical consumer (50) are connected in series, the control device (22) being implemented for measuring the current flowing through the consumer, the voltage drop across the consumer, and the change over time of the voltage drop across the consumer (50) by means of an analog circuit by detecting the charging current of a model capacitor (20), **characterized in that**, the control device is further implemented for calculating a permissible operating current level from the voltage drop across the electrical consumer (50) and a prescribed maximum value for the power consumption of the electrical consumer (50) by means of a digital calculating operation, and for calculating a charging current level of the capacitive load from the change over time of the voltage drop across the electrical consumer (50), and for calculating a permissible instantaneous current level from the permissible operating current level and the charging current level, and for comparing the permissible instantaneous current level with the level of the current flowing through the electrical consumer (50) by means of a comparator (40) and for increasing the electrical resistance of the switching element (12) if the level of the current flowing through the electrical consumer (50) is greater than the permissible instantaneous current level.

11. The device (10) according to claim 10, **characterized in that** the device (10) is implemented as a component of a power supply unit and the power supply unit is implemented as a direct-current converter, particularly as a step-up converter.

12. The device (10) from claim 11, **characterized in that** the power supply unit is implemented and provided for connecting an electrical consumer (54) to a vehicle electrical system having an operating voltage in the range of 12V to 48V.

## Revendications

1. Procédé pour la surveillance de la consommation de puissance d'un consommateur électrique (50) à l'aide d'un élément de commutation commandable (12), dans lequel le consommateur électrique (50) comporte une charge capacitive,
l'élément de commutation (12) commandable et le consommateur électrique (50) sont couplés en série ;
l'intensité du courant circulant à travers le consommateur électrique (50) est mesurée ; la tension baissant au niveau du consommateur électrique (50) est mesurée ;
et la variation temporelle de la tension baissant au niveau du consommateur électrique (50) est mesurée ;
**caractérisé en ce qu'**une intensité de courant de service autorisée est calculée sur la base de la tension baissant au niveau du consommateur électrique (50) et d'une valeur maximale allouée pour la consommation de puissance du consommateur électrique (50) ; une intensité de courant de charge de la charge capacitive est calculée sur la base de la variation temporelle de la tension baissant au niveau du consommateur électrique (50) ;
une intensité de courant momentanée autorisée est calculée compte tenu de l'intensité de courant de service autorisée et de l'intensité de courant de charge ;
l'intensité du courant momentanée autorisée est comparée avec l'intensité du courant circulant à travers le consommateur électrique et la résistance électrique de l'élément de commutation (12) est augmentée si l'intensité du courant circulant à travers le consommateur électrique (50) est supérieure à l'intensité du courant momentanée autorisée.

2. Procédé selon la revendication 1, dans lequel l'intensité de courant momentanée autorisée est calculée sur la base de l'intensité de courant de service autorisée, de l'intensité de courant de charge et d'une composante continue allouée.

3. Procédé selon la revendication 1 ou 2, dans lequel l'intensité de courant de service autorisée est calculée à l'aide d'un couplage numérique (26).

4. Procédé selon la revendication 1 ou2, dans lequel la variation temporelle de la tension baissant au niveau du consommateur électrique est mesurée à l'aide d'un couplage analogique.

5. Procédé selon la revendication 4, dans lequel un condensateur modèle (20) est couplé en parallèle avec le consommateur électrique (50), le courant de charge du condensateur modèle (20) est mesuré et la variation temporelle de la tension baissant au niveau du consommateur électrique (50) est calculée sur la base du courant de charge du condensateur modèle (20).

6. Procédé selon la revendication 5, dans lequel une résistance de mesure (72) est couplée en série avec le condensateur modèle (20) et un détecteur (76) de valeur de crête est couplé en parallèle avec la résistance de mesure (72), sachant que la tension du détecteur (76) de valeur de crête est déterminée et le courant de charge du condensateur modèle (20) est calculé sur la base de la tension du détecteur (76) de valeur de crête.

7. Procédé selon l'une des revendications précédentes, dans lequel l'élément de commutation (12) est commuté dans un état non conducteur si l'intensité du courant circulant à travers le consommateur électrique (50) est supérieure à l'intensité du courant momentanée autorisée.

8. Procédé selon l'une des revendications précédentes, dans lequel l'élément de commutation (12) est un transistor et la résistance électrique du transistor est régulée par excitation de la tension de grille ou de la tension de base du transistor.

9. Procédé selon l'une des revendications précédentes, dans lequel le consommateur électrique (50) et l'élément de commutation (12) sont raccordés à un réseau de bord présentant une tension de service allant de 12V à 48V.

10. Dispositif (10) pour la surveillance de la consommation de puissance d'un consommateur électrique (50), dans lequel le consommateur électrique comporte une charge capacitive, dans lequel le dispositif (10) comporte un élément de commutation commandable (12) et un dispositif de commande (22) pour l'élément de commutation commandable (12), dans lequel le dispositif (10) et le consommateur électrique (50) sont reliés électriquement de sorte de l'élément de commutation (12) et le consommateur électrique (50) soient couplés en série, dans lequel le dispositif de commande (22) se présente sous une forme pour mesurer l'intensité du courant circulant à travers le consommateur électrique, la tension baissant au niveau du consommateur électrique et pour, à l'aide d'un couplage analogique et par mesure du courant de charge d'un condensateur modèle (20), mesurer la variation temporelle de la tension baissant au niveau du consommateur électrique (50), **caractérisé en ce que** le dispositif de commande se présente en outre sous une forme pour calculer, à l'aide d'une opération de calcul numérique, une intensité de courant autorisée sur la base de la tension baissant au niveau du consommateur électrique (50) et d'une valeur maximale allouée pour la consommation de puissance du consommateur électrique (50), pour calculer une intensité de courant de charge de la charge capacitive à partir de la variation temporelle de la tension baissant au niveau du consommateur électrique (50), pour calculer une intensité de courant momentanée autorisée à partir de l'intensité de courant de service autorisée et de l'intensité de courant de charge, pour comparer l'intensité de courant momentanée autorisée avec l'intensité du courant circulant à travers le consommateur électrique (50) à l'aide d'un comparateur (40) et augmenter la résistance électrique de l'élément de commutation (12) si l'intensité du courant circulant à travers le consommateur électrique (50) est supérieure à l'intensité de courant momentanée autorisée.

11. Dispositif (10) selon la revendication 10, dans lequel le dispositif (10) se présente sous la forme d'un composant d'alimentation électrique et l'alimentation électrique se présente sous la forme d'un convertisseur de courant continu, en particulier d'un convertisseur élévateur.

12. Dispositif (10) selon la revendication 11, dans lequel l'alimentation électrique se présente sous la forme et est prévue pour raccorder un consommateur électrique (54) à un réseau de bord présentant une tension de service allant de 12V à 48V.
